# EUROPEAN PATENT APPLICATION

(11) **EP 0 849 599 A1**
(43) Date of publication of application: **24.06.1998**
(21) Application number: 97120979.6
(22) Date of filing: 28.11.1997
(51) Int. Cl.: G01R 1/073, G01R 1/04

(54) **Apparatus for contacting semiconductor die**

(30) Priority: 20.12.1996 US 770412
(71) Applicant: LSI LOGIC CORPORATION, Milpitas, CA 95035 (US)
(72) Inventor: Sayed, K. Azizi, Concord, CA 94518 (US)
(74) Representative: Liesegang, Roland, Dr.-Ing.

(57) **Abstract**

A test fixture including contact probes arranged to connect with contact pads on the surface of a semiconductor circuit device also includes a transition unit interposed between the contact probes and conductors of test channels arranged on a probe card in a spatial array, with conductors in the transition unit coupling selected contact probes with selected conductors of test channels.

## Description

### Field of The Invention

This invention relates to test probing of semiconductor devices, and more particularly to an interposed connector for arranging the electrical connections between physically arranged contact pins that are positioned to connect with contact points on the surface of an integrated circuit, and differently arranged contacts disposed to connect to test-channel conductors.

### Background of The Invention

The increasing complexity and circuit density of integrated circuits on semiconductor substrates requires increasingly more dense electrical connections to be made over the surface area of such a substrate. Current practices include approximately 1000 contact pads on the surface of a semiconductor substrate, or die, that are physically and electrically contacted at one or other times for testing during fabrication and packaging of an integrated circuit product that includes the die. A test probe may be assembled to include test probes arranged in a pattern corresponding to the physical layout of a plurality of selected contact pads on the surface of the semiconductor die, and these test probes are then wired to a tester, usually using manually soldered jumpers between contact probes and conductors of test channels. Such fabrication of tester channels is tedious, and expensive, and subject to human error. It would be desirable to eliminate such manual fabrication and the associated expenses and susceptibility to errors in the formation of a tester assembly for integrated circuits.

### Summary of The Invention

In accordance with one embodiment of the present invention, a transition unit is interposed between a probe assembly and test channels to transpose one physical array of spatially ordered probes that are mounted to connect with corresponding contact pads on the surface of a semiconductor die, into another physical array of contacts that connect with conductors of test channels. In this way, manually connected jumpers are eliminated, and various test schemes may be installed by changing the design of transition unit that is interposed between the probes and the test channels.

### Description of The Drawings

Figure 1 is a simplified partial cross-sectional view of an assembly of probes, transition unit, and probe card of a tester channel for connecting to selected contact pads on the surface of a semiconductor wafer;
Figure 2 is a plan view of a typical pattern of contact pins disposed to connect with contact pads on an integrated circuit die;
Figure 3 is a bottom perspective view of the transition unit for a pattern of contact pins similar to Figure 2;
Figure 4 is a simplified top perspective view of the transition unit of Figure 3;
Figure 5 is a plan view of a typical pattern of contacts on the transition unit for connection to tester channels; and
Figure 6 is a sectional view of a transition unit according to Figures 2 and 5.

### Detailed Description of The Invention

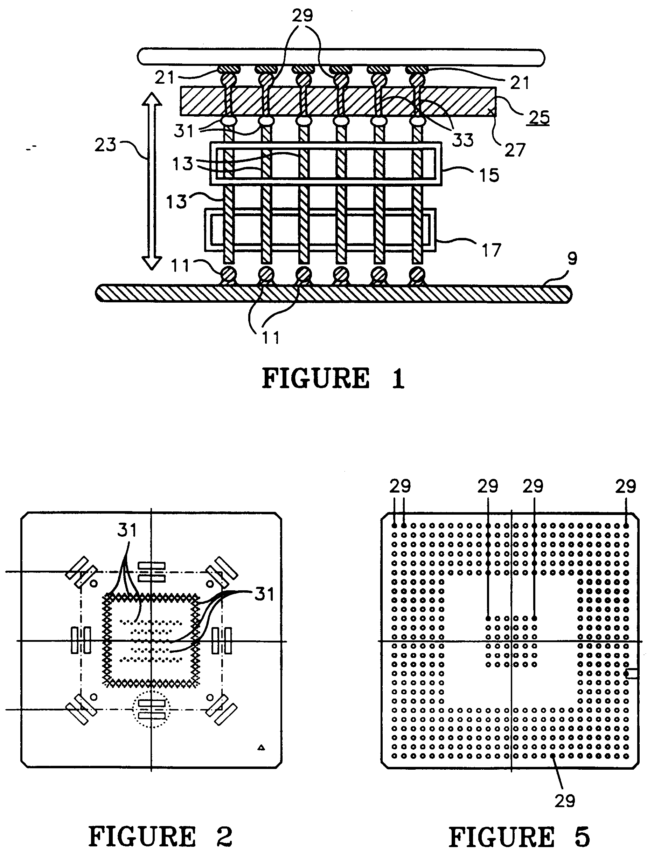

Referring now to the simplified cross-sectional view of Figure 1, there is shown a semiconductor substrate 9 having one or more integrated circuits formed therein with associated contacts 11 formed in a spatially arranged pattern on the surface. An assembly of contact pins 13 is mounted within guide plates 15, 17 in a spatial arrangement that corresponds to the spatial arrangement of a selected plurality of the contacts 11 on the surface of the substrate 9. The probe card 19 of a tester includes conductors 21 thereon of test channels that are to connect with selected pins 13 that, in turn, are mounted in guide plates 15, 17 of insulative material to move 23 into contact with the selected contacts 11.

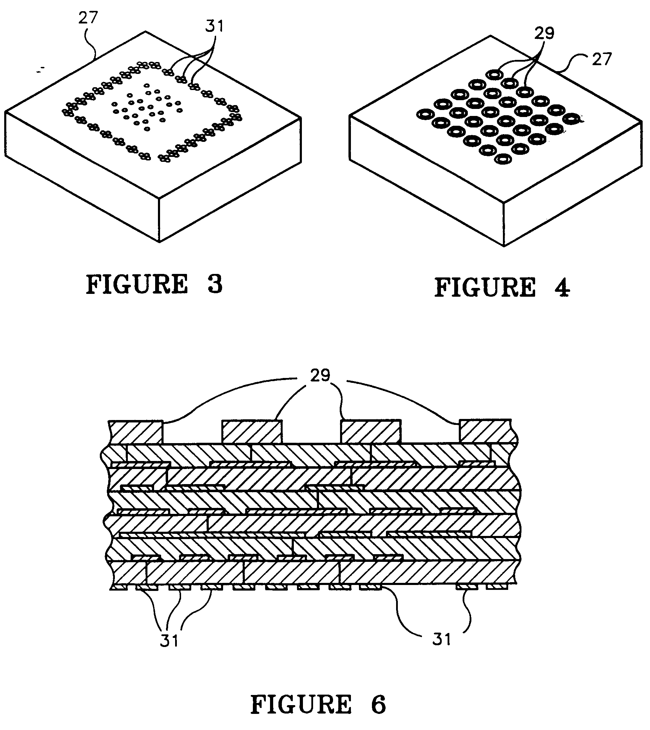

Interposed between the top ends of the probe pins 13 and the conductors 21 of test channels is a transition unit 25 that selectively arranges electrical connections between the spatial pattern of pins 13 and the pattern of conductors 21 on the probe card 19. The transition unit 25 includes an insulative substrate 27 having a plurality of top-side contact points 29 in one spatial pattern, for example, as shown in Figure 4 or Figure 5, and a plurality of bottom-side contact points 31 in another spatial pattern, for example, as shown in Figure 2 or Figure 3. Interconnections between the contact points 29 and 31 on respective upper and lower surfaces of the insulative substrate 27 are provided by conductive vias 33 that pass through the substrate 27 as conductive connections between selected upper and lower contact points 29, 31. In the illustration of Figure 1, relatively simple spatial transitions are shown completed by connections 33 between contact points 29 and 31 in corresponding locations on upper and lower surfaces of the substrate 27. However, it should be recognized that more complex interconnections can be accomplished between upper and lower contact points in a wide variety of spatial associations in order to connect a selected plurality of probe pins 13 with a selected plurality of conductors 21 on the probe card 19. In the embodiment illustrated in Figure 1, a substrate 27 may be formed of ceramic or plastic material and the vias 33 through the substrate 27 may be formed by chemically etching or Laser 'drilling' apertures or through-channels that are then filled with metal, conductive polymer, or the like. A plurality of such layers, some including surface conductors in selected connection patterns to connect with vias through adjacent layers, may all be stacked in alignment, as shown in Figure 6, to form complex interconnections between upper and lower physical arrangements of contacts.

Therefore, the transition unit of the present invention facilitates complex connections between probe pins for a semiconductor device and conductors of testing channels, and obviates the conventional practice of assembling manual interconnections of jumpers between selected probe pins and the conductors of testing channels.

## Claims

1. An electrical assembly for contacting test points spatially arranged on the surface of a semiconductor device, the assembly comprising:
a plurality of electrically conductive contact probes mounted in spatial arrangement substantially corresponding to the arrangement of test points on the surface of the semiconductor device;
a plurality of conductors disposed in a spatial arrangement for connection to selected ones of the plurality of contact probes; and
a transition unit including a substrate of non-conductive material having opposite surfaces and including a first plurality of contact pads disposed in one spatial arrangement on one of the surfaces substantially corresponding to the spatial arrangement of connections to the contact probes, and including a second plurality of contact pads disposed in another spatial arrangement on another surface opposite the one surface of the substrate substantially corresponding to the spatial arrangement of the conductors, and including conductive connections through the substrate between selected ones of the contact pads on said one and another surfaces of the substrate.

2. The electrical assembly according to claim 1 wherein the transition unit includes a plurality of stacked layers of non-conductive material having conductors thereon disposed in selected array for connecting with conductive connections through adjacent layers for forming continuous conductive paths between contacts on said one of the surfaces of the transition unit, along one or more conductors on and through plural layers of the transition unit, to selected ones of the contacts on said opposite surface of the transition unit.

3. An electrical assembly for interconnecting a plurality of electrically conductive test probes arranged in one physical pattern substantially corresponding to selected connection points on a semiconductor device and a plurality of conductors arranged in another physical pattern substantially corresponding to a selected pattern of conductors of test channels, the electrical assembly comprising:
an insulator having opposed first and second surfaces with contacts on the first surface disposed in a pattern substantially similar to said one physical pattern, and with contacts on the second surface disposed in a pattern substantially similar to said another physical pattern, and including in the insulator:
a plurality of conductors selectively interconnecting the contacts on said first and second surfaces.

4. The electrical assembly according to claim 3, wherein said insulator includes a plurality of stacked layers of insulating material, each including conductors thereon and vias therethrough in contact with conductors thereon and with conductors in adjacent layers for forming thereby continuous conductive paths between contacts on said first and second surfaces along said conductors on layers and said vias through said layers.
